# EUROPEAN PATENT APPLICATION

(11) **EP 3 882 955 A1**
(43) Date of publication of application: **22.09.2021**
(21) Application number: 20164000.0
(22) Date of filing: 18.03.2020
(51) Int. Cl.: H01L 21/033, H01L 29/66

(54) **A METHOD OF MANUFACTURING A SEMI-CONDUCTING THIN FILM DEVICE**

(71) Applicant: Nederlandse Organisatie voor toegepast- natuurwetenschappelijk Onderzoek TNO, 2595 DA 's-Gravenhage (NL)
(72) Inventor: Mameli, Alfredo, 2595 DA's-Gravenhage (NL); Kronemeijer, Auke Jisk, 2595 DA 's-Gravenhage (NL); Roozeboom, Freddy, 2595 DA 's-Gravenhage (NL)
(74) Representative: V.O.

(57) **Abstract**

The present disclosure relates to a method of manufacturing a thin film device (100). A multilevel nanoimprint lithography template (20) is transferred into a thin film stack comprising an electrode layer (11) and a blanket sacrificial layer (12) covering the electrode layer. The template is transferred, thereby patterning the device (100) and exposing a predefined insulating area (A2) of the electrode while keeping a remaining portion (12a) of the sacrificial layer that covers a predefined electrical contact area (A1) of the electrode. An area selective ALD process is performed to selectively cover the exposed area of the electrode layer with a cover layer. After removing the remaining portion (12a) of the sacrificial layer (12) the electrical contact area (A1) of the electrode layer (11) is exposed for further processing.

## Description

### TECHNICAL FIELD AND BACKGROUND

The present disclosure relates to a method of manufacturing a semi-conducting thin film device. More specifically, the disclosure relates to methods comprising use of a multilevel nanoimprint lithography template and an area selective ALD process.

There is an ever-increasing demand for smaller, higher performance semi-conducting devices. The manufacturing of semi-conducting thin film devices typically requires a multitude of patterning steps each typically involving one or more deposition, lithography and/or etching steps. As the complexity, e.g., a number of transistors, of a device increases, constraints on patterning methods are tightened, e.g., regarding resolution. At the same time, there is a continuing drive to reduce complexity of manufacturing methods and/or total number of process steps required for the manufacturing of semi-conducting devices. Typically, manufacturing of (three-dimensional) interconnect structures requires a plurality of photolithography and etching steps, e.g., to selectively open a contact area to an electrode layer. For example, a typical process flow of TFT may start with a first patterning procedure using a first mask to define a gate structure. Deposited thereon are functional layers including, e.g. an insulator layer, a semiconductor layer and a source/drain contact layer. Manufacturing of the source-drain contact structure typically requires a further patterning step, e.g., photo lithography. Subsequently, definition of the channel width and formation of a contact hole requires a further patterning step, commonly involving deposition of yet a further photoresist layers and the use of yet a further mask.

US20170330794A1 relates to the use of a via blocking layer. The blocking layer is used to insulate select vias within a given interconnect layer so a conductive routing deposited thereon can skip those select isolated vias. The ability of a deposited conductive routing layer to skip select isolated vias is attained by atomic layer deposition of an insulator layer on the metal contact of a select via. To prevent deposition of the insulator layer on the side walls these walls are covered by a blocking layer. In order to only block select vias, the method requires a first dedicated patterning step to shield other components, e.g., other vias, from the blocking layer and/or insulator layer deposition process. The blocking layer deposition process in turn may rely on an area selective assembly process and/or on area unselective deposition of a blanket blocking layer, followed by a lithography process to open select areas in the blanket blocking layer. Depending on the way the blocking layer is disposed the method of US20170330794A1 fails to a larger or smaller extent to reduce a number of required process steps, in particular with regard to the number of the required patterning, e.g., masking, steps. Accordingly there remains a need for a method of manufacturing thin film devices that is suited for selective deposition of a material on distinct target areas of a same composition benefitting from a reduced number of process steps.

US 10243080B2 relates to selective deposition utilizing sacrificial blocking layers for semiconductor devices, more specifically to selective deposition of oxide films. Similar to US20170330794A1 the method of US10243080B2 requires a number of processing steps prior to applying the blocking layer, e.g., to form a window at which the blocking layer is to be applied. The selective deposition of the oxide in turn, comprises a first selective deposition process for selectively depositing the sacrificial blocking layer and a second selective deposition process for deposition of the oxide films. Accordingly, US10243080B2 fails to reduce a number of required process steps.

Accordingly there remains a need for more effective, less time consuming, and/or less complex, and accordingly less costly, methods of manufacturing a thin film device, in particular a multi-layer thin film device.

### SUMMARY

Aspects of the present disclosure relate to a method of manufacturing a semi-conducting thin film device. The method comprises providing a stack of thin films, e.g. device layers. The stack comprises at least an electrode layer. In some embodiments, the stack comprises one or more further underlying device layers. The stack forms a basis for manufacturing of the device. Preferably before patterning the electrode layer, a blanket sacrificial layer is deposited on the stack to cover the electrode layer. In a subsequent step a multilevel nanoimprint lithography template is provided on the blanket sacrificial layer. The multilevel nanoimprint lithography template is arranged to, upon pattern transfer, pattern at least a portion of the underlying sacrificial layer and the electrode layer. In some embodiments, the multilevel nanoimprint lithography template is further arranged to, upon patterning, also pattern at least portions of further underlying device layers. To pattern the electrode layer the multilevel nanoimprint lithography template comprises at least a first portion at a first level and a second portion at a second level, different from the first level. The first portion corresponds to a pre-defined electrical contact area of the electrode layer. The second portion corresponds to a pre-defined insulating area of the electrode layer.

In some embodiments, the provided thin film stack comprises a buried further electrode layer and an insulator layer separating the electrode layer and the further electrode layer. Accordingly, the multilevel nanoimprint lithography template preferably comprises a further portion at a further level, different from the first and second level. The further portion corresponds to a pre-defined contact area of the further electrode layer. The level of the further portion is arranged such that, upon transfer, the pre-defined contact area of the further electrode layer is exposed. By providing a multilevel nanoimprint lithography template comprising a further portion at a further level, more complex portions of the device, e.g. the top electrode and underlying device layers, can be defined in a single pattern transfer step. Preferably, the multilevel nanoimprint lithography template is arranged to define the thin film device including its electrode with the contact area and non-contact area. Advantageously the use of the multilevel nanoimprint lithography template having a further level allows definition of a complex multilevel thin film device in a reduced number of patterning steps, e.g., as compared to a process including a separate photolithographic patterning process to define a contact window on an exposed electrode layer. Accordingly, a number of patterning steps can be minimized reducing for example process time and/or manufacturing process costs.

The multi-nanoimprint lithography template is transferred, e.g., etched, into the thin film stack thereby patterning the thin film device. The patterning exposes the predefined insulating area of the electrode layer and the predefined contact area of the deeper lying further electrode, if present, while keeping a remaining portion of the blanket sacrificial layer that covers the pre-defined electrical contact area of the electrode layer. Exposing part of the electrode layer that pertains to a predefined insulating area of the electrode layer while retaining a portion of the blanket sacrificial layer that covers a pre-defined electrical contact area of the electrode may be attained by a timely termination of the patterning process. The patterning time may depend on a patterning rate, e.g., an etch rate in combination with a thickness of the multilevel nanoimprint lithography template. Timely termination of the patterning process may be experimentally determined, e.g., visually. In some embodiments, the stack is provided with a marker, e.g., a visual or electrical marker, placed in the stack at a corresponding depth.

After pattern transfer (patterning), a cover layer of a cover material is selectively deposited on the exposed area of the electrode layer. Selective deposition can be understood as a preferential deposition on an intended target area accompanied by a comparatively lower, preferably an essentially absent deposition on other, non-target, areas. In a preferred embodiment, the cover material is deposited with an area selective ALD process (AS-ALD). The area selective ALD process is arranged to have a deposition rate of the cover material that is comparatively high, e.g. higher on the electrode layer than on the sacrificial layer and/or higher than on the further electrode. Accordingly, the patterned sacrificial layer enables provision of a method that allows selective deposition of a given material on an exposed area of a substrate of a first composition over at least two other exposed areas of different composition on the same substrate. The use of the sacrificial layer may be understood to provide chemical contrast for the area selective ALD process allowing simultaneous processing of multiple layers in a multi-layers thin film device 100 without a separate need to pattern and/or protect each layer individually. Thus mitigating a need for further patterning or shielding steps as commonly used in known manufacturing processes, e.g., as described in US20170330794A1 and US10243080B2, in which the selective deposition is limited to a material of a first composition over one other material.

A further advantage of using a multilevel nanoimprint lithography template, as described herein, is that the pattern definition is no longer dependent on a (large-area) photolithographic tool. Instead pattern definition relies on a reusable master that can be realized separately, e.g., with other lithographic means. Thus, the method reduces a need for, and/or a load of, large-area lithographic tools, improving throughput and/or reducing manufacturing costs while still benefitting from a high attainable patterning resolution compared to methods relying on standard optical patterning tools. Thus further allowing manufacturing of high resolution, e.g., smaller and/or denser devices, using low cost manufacturing tools.

In a preferred embodiment, the cover layer is of an electrically insulating cover material. Provision of an electrically insulating cover layer may, in use, protect parts (e.g., the predefined insulating area of the electrode) of the underlying electrode from undesired contact.

Following area selective deposition of the cover material the remaining portion of the sacrificial layer is removed. By removing the remaining portion of the sacrificial layer the electrical contact area of the electrode layer is exposed. Preferably at least part of the cover layer remains as the sacrificial layer is removed such that the pre-defined insulating area of the electrode layer remains covered.

Providing the template with at least a first portion and a second portion can, upon transfer, define an overall shape of a complex electrode wherein the first portion corresponds to a first portion of the electrode and the second portion corresponds to a second, e.g., adjacent, portion of the electrode. Providing the template with different levels allows defining, e.g. etching, to different levels, e.g., heights within the underlying thin film stack of films. By providing the template at least a first portion at a first level and a second portion at a second level, that is a different height from the first level, allows defining, e.g., etching the lithography template into the thin film stack 10 thereby patterning, the thin film device 100 and exposing a predefined insulating area of the electrode layer while keeping a remaining portion of the blanket sacrificial layer that covers a pre-defined electrical contact area of the electrode layer.

Patterning the stack with a template with at least a first portion, a second portion and a further portion can in combination with the use of the area selective ALD process allow the manufacturing of a thin film device including an electrode with a contact and non-contact area as well as a contact area of the semi-conductor layer in a reduced number of manufacturing steps. Thereby, mitigating a need for separate masking and/or patterning steps, e.g., photolithography steps, to define contact and non-contact areas of the electrode layer.

In some embodiments, the method comprises performing a metallizing process to form an electrically conductive contact pad on the exposed contact area of the electrode layer. Additionally, the method may comprise performing a metallizing process to form an electrically conductive contact pad on the exposed contact area of the further electrode layer, e.g., the semiconductor layer. Preferably, the electrically conductive contact pads on the electrode layer and the further electrode layer are formed in a single metallizing step.

Further aspects of the present disclosure related to a use of the method according to the invention in the manufacturing of thin film devices, in particular in the manufacturing of thin film transistors, e.g., a FET or a MOSFET device.

### BRIEF DESCRIPTION OF DRAWINGS

These and other features, aspects, and advantages of the apparatus, systems and methods of the present disclosure will become better understood from the following description, appended claims, and accompanying drawing wherein:
FIGs 1A-D and 2A-C schematically illustrate an embodiment of the method of manufacturing of a thin film device at various stages;
FIGs 3A and B and 4A and B schematically illustrate further embodiments of the method of manufacturing of a thin film device at various stages;
FIG 5 schematically illustrates the area selective ALD process;
FIG 6A and B depict area selective growth rate;
FIGs 7 and 8 illustrate various stages of an embodiment of the method applied to the manufacturing of a TFT device.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

As used herein the term 'blanket layer' can be understood to include layers covering one or more underlying layers. In particular, the term 'blanket layer' can be understood to also include layers covering one or more predefined areas that are to be patterned in said underlying layer.

As used herein the electrode layer can be characterized in having a low electrical resistivity p as opposed to an electrically insulating layer having a high electrical resistivity. Typically, the electrode layer is formed of an electrode material having an electrical resistivity less than about one µΩ.cm, preferably less e.g., less than 0.1 or even 0.01 µΩ.cm at twenty degrees Celsius as opposed to an electrically insulating material (low or high κ dielectric) characterized in having an electrical resistance p in excess of 10 MΩ·m at 20 °C, preferably higher, e.g., in excess of 10¹⁰ Ω·m, or more, e.g., in excess of 10¹³ or 10¹⁴ Ω·m, e.g. in a range between 10¹³ Ω·m and 10¹⁵ Ω·m.

The invention is described more fully hereinafter with reference to the accompanying drawings, in which embodiments of the invention are shown. In the drawings, the absolute and relative sizes of systems, components, layers, and regions may be exaggerated, e.g., not to scale for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

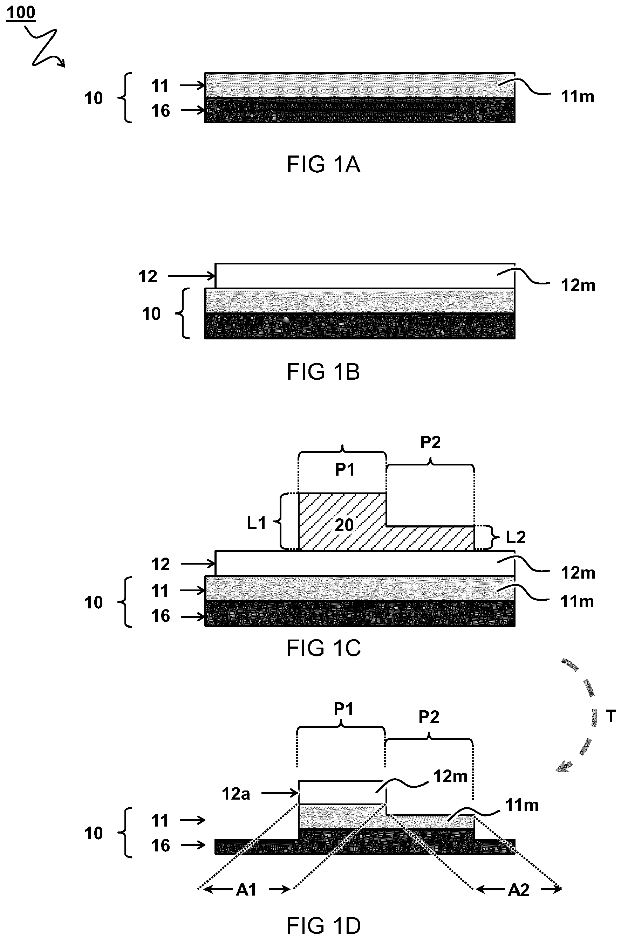

FIGs 1A to 2C schematically illustrate cross-section side views of an embodiment of the method of manufacturing of a thin film device 100 at various stages of completion.

Depicted in FIG 1A a schematic cross section side view of a thin film stack 10 at an initial phase of the manufacturing method of a thin film device 100. The stack comprises 1 electrode layer 11 of an electrode material 11m. Depicted below the electrode layer 11 is one or more additional layer 16, e.g. an insulating layer. As described herein the electrode layer 11 can be patterned to from an electrode as comprised in the thin film device 100. In some embodiments, the one or more additional layer 16 is patterned along with the electrode material 11. In some embodiments, the electrode 11 may be formed of an electrode material 11m having an electrical resistivity, below about one mΩ.cm or less, e.g. below 0.1 mΩ.cm, e.g., a metal. In other embodiments, the electrode layer 11 may be formed of a semi-conducting electrode material 11m, e.g. a doped semi-conducting material. The thickness of the electrode layer 11 typically corresponds to a thickness of the electrode comprised in the thin film device 100. Typically, the electrode layer 11 has a thickness in a range between about one hundred or two hundred nanometer and one hundred micrometer, e.g., in a range between five hundred nanometer and ten micrometer, e.g., about one or about five micrometer.

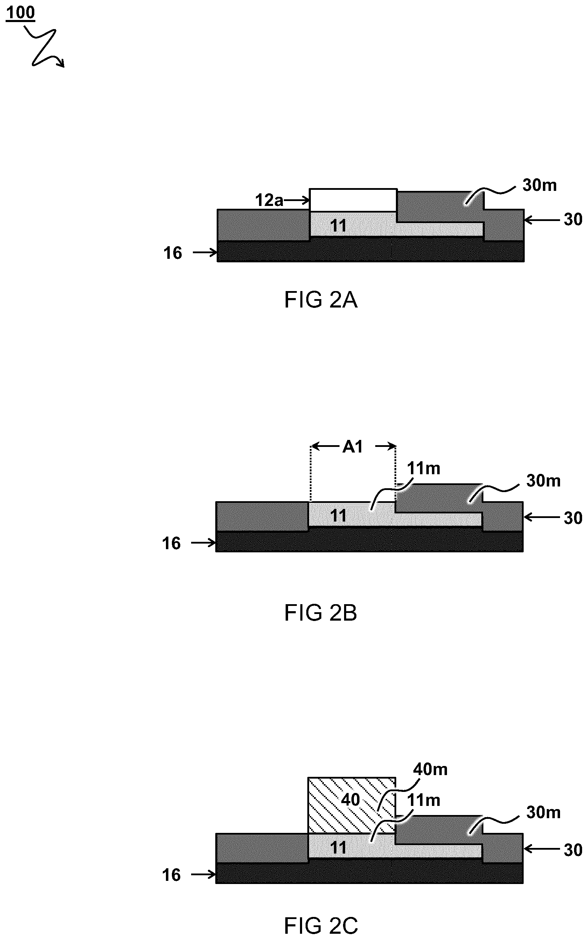

Deposited on the electrode layer 11 is a blanket sacrificial layer 12. The blanket layer, as shown, the underlying electrode layer 11 including one or more predefined areas to be patterned in said underlying layer (see e.g., FIG 1D). The sacrificial layer can be formed of a sacrificial material 12m or combination of such materials 12m. The sacrificial layer 12 and a sacrificial material 12m can be characterized in an ability to be selectively removable using standard thin film manufacturing processes such as etching. Although the sacrificial layer 12, as shown, is deposited on the thin film stack 10 it will be understood that the sacrificial layer 12 will not necessarily be comprised in a final product, e.g., a thin film device 100 such as a MOSFET of TFT device manufactured using the method according to the invention. Removal of the sacrificial material (as e.g., explained in relation to FIG 2B) can be obtained by selective etching, e.g., selective wet etching. For example, a sacrificial layer 12 of aluminum oxide with a selective wet etchant. The blanket sacrificial layer 12 can be deposited using any suitable deposition method, e.g., vapor deposition or atomic layer deposition (ALD). Advantageously, as will be explained herein, deposition of the sacrificial layer 12 does not require high resolution patterning techniques. The thickness of the sacrificial layer can depend on the type of device manufactured. The sacrificial layer 12 has a thickness in a range having a lower value of about five nanometers or one hundred nanometers, and an upper value up to several micrometers e.g., ten micrometers. Typically, the thickness is in a range between ten nanometers and one hundred or two hundred nanometer.

On to the sacrificial layer 12 there is provided a multilevel nanoimprint lithography template. The multilevel nanoimprint lithography template 20 of a template material, e.g. as shown in FIG 1C, comprises at least a first portion P1 at a first level L1 and a second portion P2 at a second level L2, different from the first level L1. Portion P1 corresponds to a pre-defined electrical contact area (A1, see e.g. FIG 1D) of the electrode layer 11. Portion P2 corresponds to a pre-defined insulating area (A2, see FIG 1D) of the electrode layer 11. Methods of providing a nanoimprint lithography template are may be known per se. The multilevel nanoimprint lithography template including the described portions are preferably formed of a composition allowing reliable transfer of the template to the stack of layers below. Transfer can be performed by any known nanoimprint lithography method, typically etching, preferably a homogeneous etching procedure, wherein the template performs as a resist reducing etching at locations that are covered by the template while material of layers adjacent to the resist is etched. In a preferred embodiment, transfer is normally performed in a dry etching procedure, e.g., reactive ion etching.

Typically, providing the multilevel nanoimprint lithography template 20 comprises providing an imprint resist coating, e.g., onto the thin film stack 10. Subsequently, an imprint mold having the predefined 3D structure, is pushed into the imprint resist layer such that its 3D pattern is transferred into the imprint resist. Optionally provision of the imprint resist coating may be preceded by provision of an adhesion promotor layer (not shown) or an adhesion promotion step, such as an oxygen plasma treatment, to improve adhesion of the multilevel nanoimprint lithography template 20.

The formed 3D pattern forms a template for patterning the underlying device layers including the blanket sacrificial layer 12 disposed thereof. The thickness of multilevel nanoimprint lithography template 20 and its levels correspond to a thickness of the underlying device layers. Upon pattern transfer T, the template is transferred into the underlying layers, as shown in FIG 1D. Thereby patterning the thin film device 100 from the stack 10 and exposing the predefined insulating area A2 of the electrode layer while keeping a remaining portion 12a of the blanket sacrificial layer 12 that covers the pre-defined electrical contact area A1 of the electrode layer 11.

Providing the template with at least a first portion P1 and a second portion P2 allows defining, e.g., etching, of an overall shape of an electrode wherein the first portion corresponds to a first portion of the electrode and the second portion corresponds to a second, e.g., adjacent, portion of the electrode. By providing the template with different levels allows defining, e.g., etching, to different levels, e.g., heights within the underlying thin film stack of films. By providing a template with at least a first portion P1 at a first level L1 and a second portion P2 at a second level L2 that is a different height from the first level, allows defining, e.g., etching the lithography template 20 into the thin film stack 10, allows minimizing a number of required processing steps as the multilevel nanoimprint lithography template 20 can be arranged to patterning the thin film device 100 in a single transfer step that comprised exposing a predefined insulating area A2 of the electrode layer while keeping a remaining portion of the blanket sacrificial layer 12 that covers a pre-defined electrical contact area A1 of the electrode layer 11.

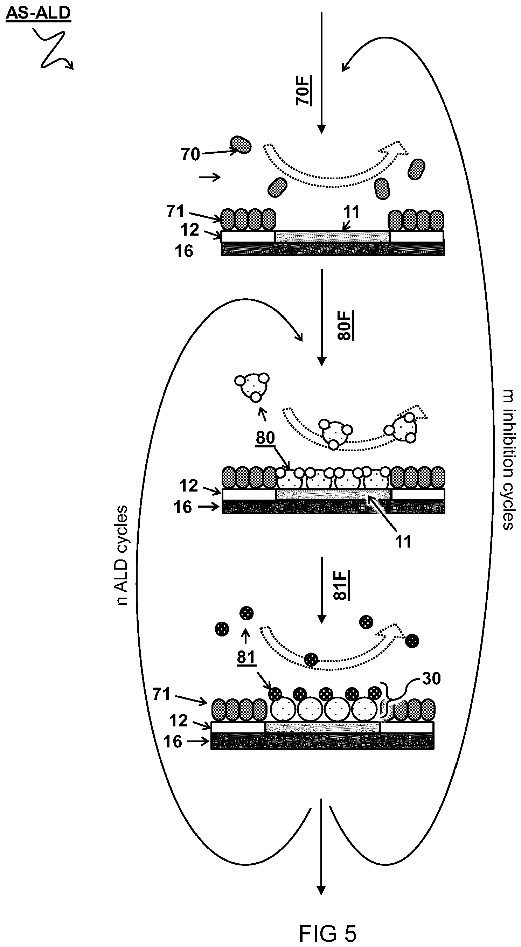

The patterned stack is exposed to an area-selective deposition process. FIG 2A schematically depicts the patterned stack as shown in FIG 1D wherein exposed insulating area A2 of the electrode layer 11 onto which a cover layer 30 of a cover material 30m after performing an area selective ALD process (AS-ALD). The area selective ALD process is arranged to have a deposition rate of the cover material 30m that is comparatively higher on the electrode layer 11 than on the on the sacrificial layer 12. Optionally the selective ALD process can be further arranged to have a deposition rate of the cover material 30m that is comparatively higher on the electrode layer 1 than on the additional layer 16 (not shown). The AS-ALD process may be understood to relate to an ALD process wherein the material to be deposited is preferentially deposited on one material over one or more other materials. Area selective deposition or preferential deposition may be understood to relate to deposition having a deposition rate of the material that is to be deposited, e.g., the cover material 30m, that is comparatively higher on the on the target deposition area over target non-deposition areas. In AS-ALD one or more of, the process conditions, the inhibitor, the precursors and co-reactants to the material that is to be deposited, are mutually selected, e.g. tuned, to allow selective deposition of cover material on a layer of a given composition over a layer of a given other composition. Preferably, the relative deposition rate of the cover material 30m on the target material is at least three times higher than on the non-target areas, more preferably the deposition rate is at least a factor five higher or more, e.g., ten times. Higher relative differences allow more selective deposition, e.g., per given number of ALD deposition cycles. Preferably, the absolute deposition rate of the cover material 30m on the target material is of the order of 0.1 nm per ALD cycle. Preferably, deposition on non-target areas is negligible. Deposition of cover material 30m on the sacrificial layer 12 could disadvantageously hamper future removal of the remaining portion of the sacrificial layer 12a. Accordingly, the sacrificial layer 12, the electrode layer 11, and optionally the additional layer 16 may be understood to be selected such that a deposition rate of the cover material 30m on the sacrificial layer 12 is comparatively lower than on the electrode layer 11. In a preferred embodiment, the cover layer 30 is an electrically insulating cover layer, e.g., silicon dioxide (SiOₓ). Provision of an electrically insulating cover layer may protect the electrode of the thin film device 100 from undesired contact, e.g., in use. Details regarding the AS-ALD will be explained in more detail later in relations to FIG 5.

After depositing the cover layer 30 the remaining portion 12a of the sacrificial layer 12 is removed to expose the electrical contact area A1 of the electrode layer 1. FIG 2B schematically depicts the stack in a state after removing the cover layer 30. As described removal of sacrificial material 12m performed by any suitable method, such as wet etching. Preferably, as shown, the sacrificial layer 12 and cover layer 30 are selected such that the sacrificial layer 12 can be selectively removed. For example, one of the sacrificial layer 12 and cover layer 30 can be AlOₓ-based, whereas the other can be SiOₓ-based.

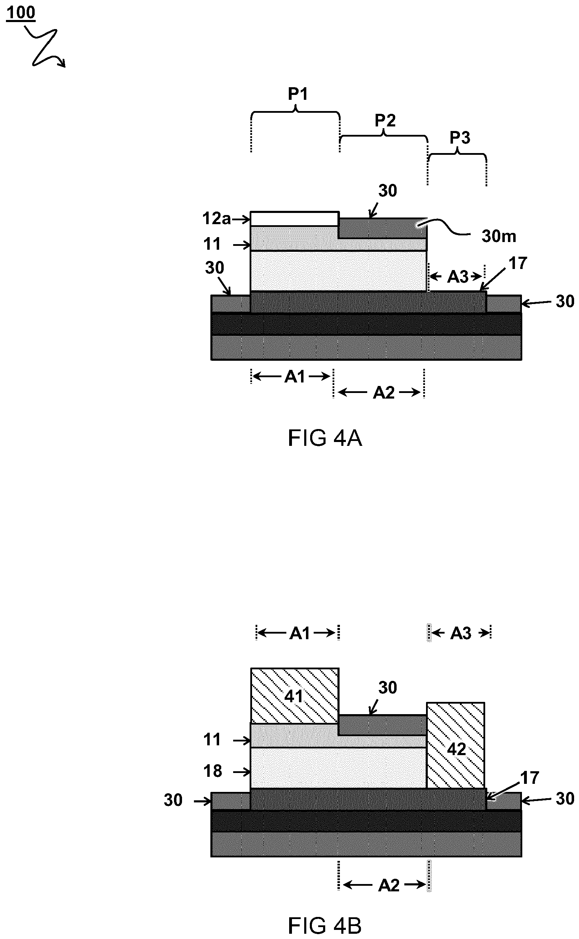

In some embodiments, e.g., as shown in FIG 2C, the method comprises performing a metallizing process to form an electrically conductive contact pad 41 on the exposed contact area A1 of the electrode layer 11. The metallization can comprise electrodeposition of an electrically conductive material 41m, e.g., a metal. As the insulating area A2 is not exposed deposition of a contact pad thereon can be avoided. Optionally or additionally (e.g. as shown in FIG 4B) the method can comprises performing a metallizing process to form an electrically conductive contact pad 42 on the exposed contact area of a further electrode layer, e.g. deeper lying electrode layer 17. Advantageously, the electrically conductive contact pads on the electrode layer 11 and the further electrode layer 17 can be formed in a single metallizing process.

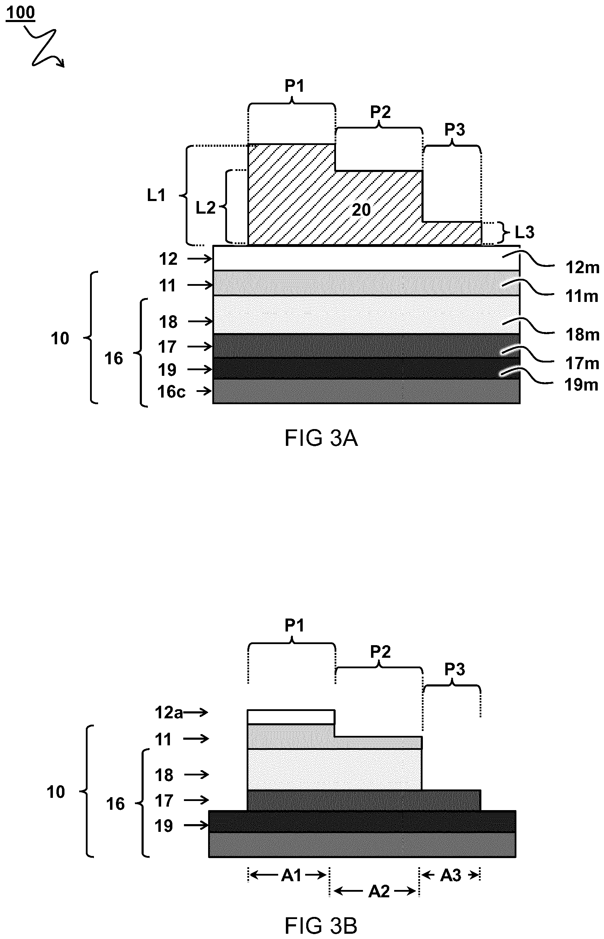

In other or further embodiments, a thin film stack comprises (is provided with) further additional layers 16. In some embodiments, e.g. as shown in FIG 3A the stack 10 comprises a buried further electrode layer 17 and an insulator layer 18 separating the electrode layer 11 and the further electrode layer 17. Optionally, the stack may comprise further layers such as buffer layers 19 of a buffer material 19m and/or or a carrier 16c. Provided to the sacrificial layer 12 is a multilevel nanoimprint lithography template 20 that comprises a further portion, e.g., third portion P3, at a further level L3, different from the first and second level. The third portion corresponds to a pre-defined contact area A3 of the further electrode layer 17. The third portion corresponds has a thickness (level) such that upon transfer, the pre-defined contact area A3 of the further electrode layer 17 is exposed (See FIG 3B). Accordingly, the multi- level nanoimprint lithography template 20 including the third portion may be understood to be arranged to define the thin film device 100 including its electrode with the contact area and non-contact area. Advantageously the use of multilevel nanoimprint lithography template 20 having a further level allows definition of a complex multilevel thin film device 100 in a reduced, preferably single, pattern transfer step. Accordingly, a total number of patterning steps in the manufacturing of the thin film device 100 can be minimized reducing, for example, process time and/or manufacturing costs. In a preferred embodiment, one of the electrode layers 11, 17 is formed of a semi-conductor material, e.g., a doped semi-conductor material, whereas the other is formed of a material having an electrical resistivity below 1 mΩ.cm, e.g., below 0.1 mΩ.cm, e.g., a metal. Accordingly, the method can be applied in the manufacturing of a transistor, e.g. a FET or a MOSFET device, at reduced complexity and/or cost.

In a preferred embodiment, the deposition rate of the cover material 30m on the electrode material 11m is comparatively higher than on the further electrode layer 17. FIG 4A, schematically depicts a thin film device 100 at a stage of manufacturing after selective deposition of a cover layer 30 of a cover material 30m. As the deposition rate of the cover material 30m on the electrode material 11m is comparatively higher than on the further electrode layer 17 deposition cover material 30m on the remaining portion of the sacrificial layer 12a and on the contact area A3 of the further electrode layer 17 can be reduced, preferably essential avoided. Presence of a layer of cover material 30m, in particular of an electrically insulating cover material, on the contact area A3 of the further electrode layer 17 would disadvantageously prevent formation of an electrically conductive contact pad 42 (see FIG 4B) on further electrode layer 17.

Accordingly, the sacrificial layer 12, the electrode layer 11, and the further electrode layer 17 may be understood to be selected such that the cover material is preferentially deposited on the electrode layer 11 over the sacrificial layer 12 and the exposed part of the further electrode layer 17. Or in other words, the sacrificial layer 12, the electrode layer 11, and the further electrode layer 17 may be understood to be selected such that the deposition rate of the cover material 30m on the sacrificial layer 12 and the further electrode layer 17 is comparatively lower than on the electrode layer 11.

Advantageously use of single pattern transfer step in combination with the use of the area selective ALD process (AS-ALD) allows to define the thin film device 100 including its electrode with the contact area A2 and non-contact area A1 as well as the contact area A3 of the semi-conductor layer 17 in a reduced number of manufacturing steps, mitigating a need for separate masking and/or patterning steps, e.g., photolithography steps, to define contact and non-contact areas of the electrode layer 11.

As explained in relation to FIG 2C, in some embodiments the method comprises performing a metallizing process. Preferably, metallization, e.g., electrodeposition of an electrically conductive material to form an electrically conductive contact pad 41,42 on the exposed contact area of the electrode layer and the further electrode layer.

AS-ALD may be contrasted to conventional atomic layer deposition methods. ALD as such is known as a method for depositing a layers of a target material. Atomic layer deposition differs from for example chemical vapour deposition in that atomic layer deposition takes at least two process cycles. A first one of these cycles typically involves a self-limiting binding or chemisorption of a precursor moiety onto a target substrate surface. Following adsorption of the precursor the substrate is exposed to second cycle in which the substrate is exposed to a co-reactant that reacts with the precursor to form a first adlayer of the target material. Layer thickness can be increased by repeatedly exposing the substrate to the process cycles. To reduce, preferably essentially avoid, gas phase reaction between the precursor and co-reactant exposures are preferably separated. Process cycles may be temporally separated and/or spatially separated, such as in spatial ALD (sALD). Although known ALD methods may deposit target layers with good conformity, they lack an ability to provide spatial control over deposition areas and as such are less suitable for area-selective deposition of target material layers particularly in combination with large-scale or high- throughput deposition methods. In ACS Nano, 11, 9303-9311 (2017), A. Mameli et al., report a so-called single-wafer process that allows for selective deposition of SiO₂ on GeO₂, SiNₓ, SiO₂, and WO₃, in the presence of Al₂O₃, TiO₂, and HfO₂ surfaces using acetylacetone as inhibitor, BDEAS (H₂Si(N(C₂H₅)₂)₂) as precursor and an O₂ plasma as co-reactant. The reported process relies on a vessel type vacuum reactor in which a substrate is sequentially exposed to these three exposure steps. Accordingly, the reported process may be referred to as a temporally separated embodiment of an area selective ALD (AS-ALD). European patent application 19208861.5 discloses spatially separated embodiment of an area selective ALD process in which a substrate is transported along a series of spatially separated dosing units. Both reports (Mameli et al., and EP19208861.5) are hereby incorporated by reference.

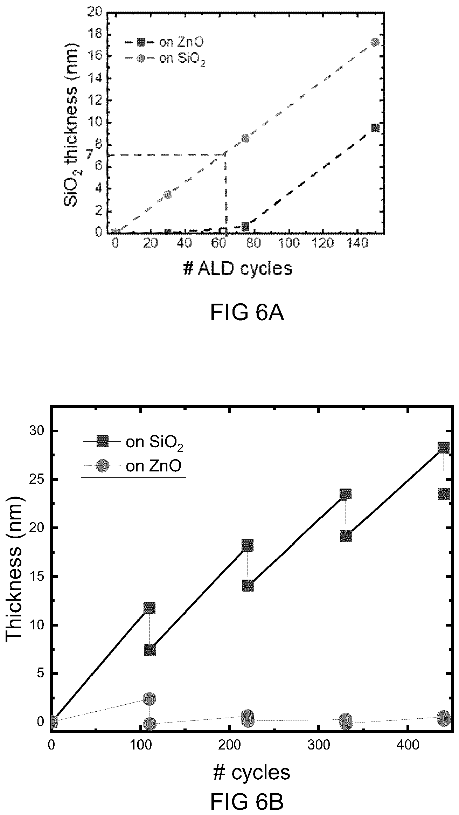

Now, in relation to FIGs 5 and 6 the area selective ALD process, AS-ALD, will be explained. Shown in FIG 5 (top) is a schematic side view of substrate comprising exposed portions of an electrode layer 11, a sacrificial layer 12 and a buried additional layer 16. In a first process step 70F the substrate is exposed to inhibitor moieties 70. As, e.g., explained in European patent application 19208861.5, the inhibitor moieties 70 are selected to comprise an adsorption selectivity towards the sacrificial layer 12 such that an inhibition layer 71 is formed thereon. On the electrode layer 11 formation of an inhibition layer can be avoided as the inhibitor moieties 70 and electrode layer 11 are selected to have low mutual affinity. Following the inhibition step 70F the substrate is exposed 80F to a flow of precursor moieties 80. The precursor moieties 80 chemisorb to the exposed portion of the electrode layer 11 forming a layer thereon. Since the reaction is typically self-limiting excess precursor moieties 80 can be removed, e.g., with a carrier gas (not shown). Areas covered with precursor moieties 80 are subsequently exposed 81F to a flow of co-reactants 81 which react with the adsorbed precursor moieties 80 to form a first adlayer of cover material constituting cover layer 30.

As known in the field, to increase the thickness of the cover layer 30 steps 80F and 81F may be repeated a plurality of times, e.g. n times. The inhibition layer is believed to inhibit adsorption of precursor moieties thus locally reducing the deposition rate of cover material 30m formed as a result of one or more subsequent precursor and co-reactant exposure cycles. Thus the inhibition layer may be understood to form a means to provided chemical contrast as to the deposition location of the cover material 30m. Materials whereon an inhibition layer is formed display low cover material 30m deposition rate, whereas materials where no inhibitor layer is formed display a high deposition rate.

Optionally, step 70F may be repeated every m times (1 ≤ m ≤ n). By repeating the inhibition a (partially) degraded inhibition layer 71 can be restored. In particular in embodiments wherein the co-reactant comprises highly reactive plasma species the inhibition step may be performed more often, e.g. before each precursor exposure.

It will be understood that the steps 70F, 80F, and/or 81F comprised in the area selective ALD process (AS-ALD) can be performed in a time resolved fashion, e.g., in a single reaction chamber in which a substrate, e.g., the thin film stack 10, is subsequently exposed to the process steps, whereby in between process steps the chamber can be purged with an inert gas and/of evacuated to remove traces from a preceding exposure. Preferably, the area selective ALD process is performed in a spatially resolved ALD tool, e.g., a device as disclosed in European patent application 19208861.5. A spatially resolved area selective ALD tool can advantageously be incorporated in a continuous manufacturing process, as opposed to a batch-wise or wafer-by-wafer manufacturing process, thus speeding up manufacturing, increasing throughput and/or reducing cost of manufacturing.

In some embodiments, the substrate, e.g., the thin film stack 10 after pattern transfer, may be transferred, e.g., moved, along a series of spatially separated deposition or process spaces. The spatially separated process spaces include a first processing space wherein the substrate, e.g., the patterned thin film stack 10, is exposed in step 70F to a process flow comprising inhibitor moieties. The spatially separated process spaces include second process space wherein the substrate, e.g., the patterned thin film stack 10, is exposed in step 80F to a process flow comprising precursor moieties 80. The spatially separated process spaces include a third process space wherein the substrate, e.g., the patterned thin film stack 10, is exposed in step 81F to a process flow comprising co-reactant moieties 81. In between spatially separated process spaces there is preferably provided a separator space in which the thin film stack 10 can be exposed to a separator flow of an inert process gas, e.g., nitrogen, separating process flows in adjacent process spaces. By separating process spaces one can advantageously reduce, preferably essentially avoid, gas phase reactions between for example a co-reactant and precursor moieties. Accordingly, in one embodiment performing the area selective ALD process (AS-ALD) includes providing relative movement between the thin film stack 10 and a plurality of deposition spaces. The plurality of deposition spaces including at least a first deposition space provided with an inhibitor supply to expose the thin film stack 10 to a process flow comprising inhibitor moieties 70; a second deposition space provided with a precursor supply to expose the thin film stack 10 to a process flow comprising precursor moieties 80; and a third deposition space provided with a co-reactant supply to expose the thin film stack 10 to a process flow comprising co-reactant moieties 81; wherein each of the deposition spaces of plurality of deposition spaces is spatially separated from an adjacent deposition space of plurality of deposition spaces by a separator space comprising an inert gas supply for exposing the thin film stack 10 to a separator flow. To increase layer thickness the sample may be repeatedly exposed to the process flows, e.g., by providing reciprocal motion.

In some embodiments, the process flow comprising inhibitor may be included in one of the separator flow, the process flow comprising precursor moieties 80, and the process flow comprising co-reactant moieties 81. By including the inhibitor into one of the other flows can reduce a footprint of the ALD tool and/or reduced process time.

In another or further embodiment, as will be explained in more detail in relation to FIG 6B the area selective ALD process (AS-ALD) may include a back-etching step. Accordingly, there can be included an etching space comprising an etchant supply to expose the thin film stack 10 to an etchant flow.

As used herein precursor or precursor moiety may be understood to include any compound, e.g. molecules, able to participate in a self-limiting reaction with reactive groups (e.g. sites) on a surface. As known in the field such precursor moieties are typically metal species comprising a central metal ion surrounded by ligands. A broad variety of precursor compounds is known in the field including but not limited to metal-halides such as aluminum chloride and hafnium chloride, and metal-organic species including but not limited to metal-alkyls, such as trimethyl aluminum and diethylzinc; -carbonyls, such as iron(0)pentacarbonyl; -alkoxides, such as titanium(IV)isopropoxide; -alkylamides, such as pentakis(dimethylamino)tantalum(V); -cyclopentadienyls, such as cobaltocene; -β-diketonates, -amidinates, and -guadinates including bis(t-butylacetoacetato)copper(II), bis(N,N'-di-sec-butylacetamidinato)dicopper(I), and tris(1,3-diisopropyl-2-dimethylaminoguadinarto)gadolinium(III).

As used herein the co-reactant may be understood to include any moiety, e.g. as known in the field of ALD, to react with an adsorbed precursor moiety. As usual in the field such moieties may be provided in a vapor or gaseous state comprised in a stream of one or more inert carriers gasses to form a co-reactant gas flow (B). Co-reactant moieties include molecular species such as water and or oxygen which may react, e.g. in a ligand exchange reaction, with adsorbed precursor moieties. Alternatively or in addition, co-reactant may be understood to include reactive plasma species. The plasma may be a remotely generated plasma, e.g. generated at an upstream position and transported to the reaction space by a carrier flow. It will be appreciated that the precursor and/or co-reactant may be comprised of a mixture of precursor-, respectively, co-reactant moieties.

Selection of what inhibitor would work on which surface is mostly dictated by surface acidity and basicity as well as basic/acid character of the inhibitor. For details, reference is made to European patent application 19208861.5 and to a publication by A. Mameli et al. in ACS Nano 11, 9303-9311 (2017), which is hereby incorporated by reference. In the case of oxidic surfaces, inventors find interaction between a surface and a potential inhibitor molecule is determined by their chemical affinity, which can be derived from the electronegativity of the cation in the oxide (as defined e.g., by Linus Pauling) and the polarizability of the bonds, typically built in the inhibitor molecule's ligand groups. This can be translated in the elements' or compounds' Bronsted acidity (proton attraction- or repulsion-based) or Lewis acidity (electron attraction- or repulsion-based). Inventors found that the following classes of inhibitors may selected: Ketones, e.g., acetone, acetophenone, methyl propyl ketone, etc.; Beta-diketones, preferably 1-2, diketones such as diacetyl, acetylacetone, hexafluoroacetyl-acetone, etc.; Primary, secondary, and tertiary alcohols, but preferably tertiary alcohols; Carboxylic acids such as ethylbutyric acid, and trimethylacetic acid; Primary, secondary, and tertiary amines such as methylamine, dimethylamine, and trimethylamine; Diamines such as ethane diamine, and small alkyl chain (Cₙ with 1<n<6) thiols such as ethane dithiol.

In ALD processes the precursor and/or co-reactant moieties are typically provided to in a flow, i.e. a precursor flow or co-reactant flow, essentially formed of an inert carrier gas mixed with a pre-determined amount (partial pressure) of the precursor moiet(y)(ies), respectively the co-reactant moiet(y)(ies).

Depending on the nature of the ALD process suitable inert gasses typically include di-nitrogen, argon, other noble gasses or mixtures thereof. In ALD processes wherein the co-reactant is a reactive plasma, e.g. an oxygen plasma, noble gasses or mixtures thereof are preferably employed as carrier and separation gas streams.

Now with reference to FIGs 6A and B there is provided experimental evidence of area-selective deposition of a layer of a cover material 30 (SiO₂) onto an exemplary substrate comprising zinc oxide (ZnO) and silicon oxide (SiO₂) terminated surface area using a spatial ALD setup (sALD). To avoid deposition on the ZnO terminated areas inhibitor moieties 70 selectively binding to ZnO were employed. The thickness of the SiO₂ layer on the deposition area (SiO₂) was found to increase steadily with increasing number of ALD cycles. Up to about 65 process cycles no target material was observed on the non-deposition area (ZnO). At this point the total thickness of deposited SiO₂ amounted to approximately 7 nm. After about 80 process cycles SiO₂ was found to be deposited on ZnO terminated areas as well.

Fig 6B relates to a similar experiment but including an exposure to an etchant after about every 110 process cycles, (110, 220, 330, and 440). Each etchant step reduces a thickness of a deposited SiO₂ layer by about 4 nm. This educed the thickness of deposited SiO₂ on ZnO-terminated surface regions to below a detection limit. As shown inclusion of the etchant step allows area-selective deposition of cover material 30m with increasing thickness beyond a level at which area unselective deposition would occur for methods not including an etching step. Accordingly, in some embodiments, the method comprises one or more back-etch steps. The back-etch arranged to remove part of the deposited cover material 30m. Incorporation of one or more back-etch process steps can advantageously remove non-selectively deposited cover material 30m, e.g. cover material 30m deposited as a result of undesirable gas phase reactions between precursor species and co-reactants. Such undesirable gas phase reactions, sometimes referred to as chemical vapor deposition (CVD) side-reactions, can occur due to non-ideal process conditions during area selective ALD process, in particular in spatial ALD deposition tools. In a preferred embodiment, the area selective ALD process comprises one or more back-etch process steps every 10, 50 or more, e.g., 100 or 200, ALD deposition process cycles. Optionally, back-etching can be performed in a dedicated tool, e.g., as a step in between the area selective ALD process and prior to removing the sacrificial layer 12. Preferably, the one or more back-etch process(es) are performed in the same tool wherein the area selective ALD process (AS-ALD) is performed, e.g., in the same spatially resolved area selective ALD tool (AS-ALD). Accordingly, in some embodiments, the spatially separated process spaces includes a further process space, e.g., an etching space, The spatially separated process spaces include third process spaces wherein the substrate, e.g., the patterned thin film stack 10, is exposed a process flow comprising an etchant.

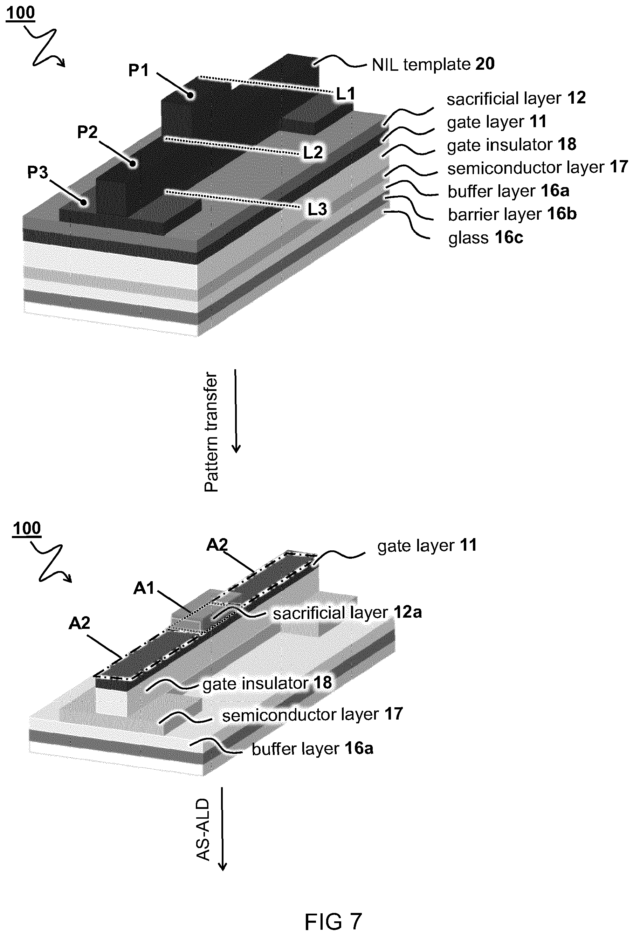

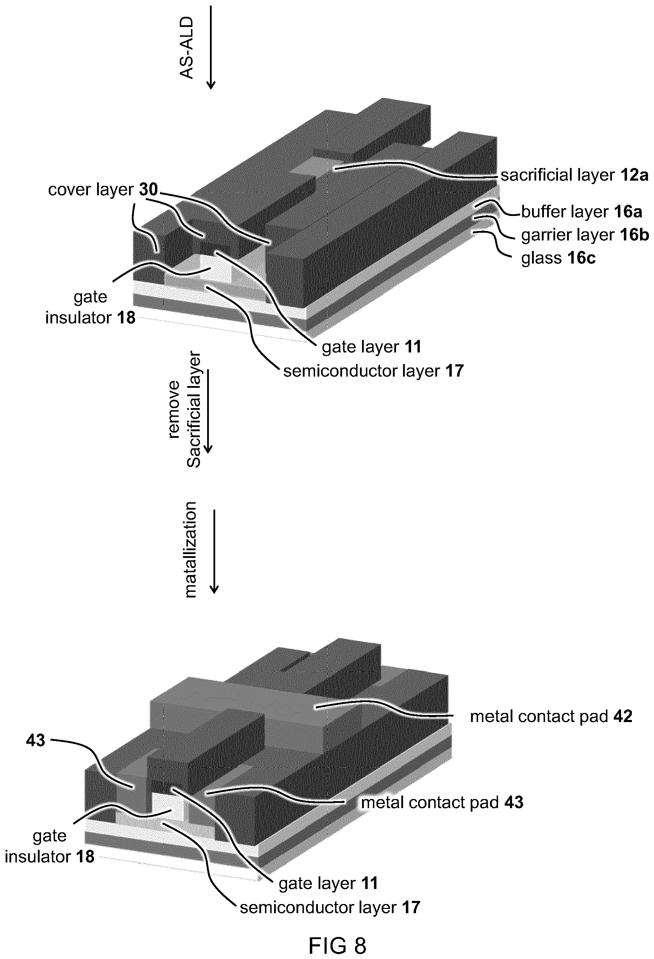

In some embodiments, wherein the method according to the invention is applied in the manufacturing of a transistor device 100, one of the electrode layer 11 and the electrode layer 17 is arranged to form a gate whereas the other is arranged to form a semi-conducting charge carrier layer. Now, with reference to FIGs 7-8 there will be explained a method of manufacturing a TFT device 100. As indicated in FIG 7 (top) a glass carrier 16c is provided a thin film stack comprising (in order from bottom to top): a barrier layer 16b, a buffer layer 16s, a doped semi-conductor layer 17 forming the further electrode layer, a gate insulator layer 18 and a gate electrode layer 11 forming the first electrode layer. Provided on the stack are a blanket sacrificial layer 12 and a multilevel nanoimprint lithography template 20. The template having three portions P1-P3, each at a different level L1-L3. In line with FIGs 3-4 the area of the portion P1 corresponds to an electrical contact area A1 of the electrode of the TFT device 100. Portion P2 corresponds to an insulating area A2 of the electrode of the TFT device 100. Area P3 corresponds to a contact area A3 of the semi-conductor layer 17. The levels (thickness) of the portion corresponds to a thickness of the underlying layers. Figure 7 (bottom) depicts the stack after pattern transfer and already indicated the formation of a transistor device that is to be formed by gate layer 11 and semi-conductor layer 17 separated by insulator layer 18. Areas A1 and A2 are indicated (dotted and dash-dotted lines in FIG 7 bottom), area A3 (not indicated) is formed by the exposed top surfaces of semi-conductor layer 17. As explained above the remaining portion 12a of the sacrificial layer 12 protects the underlying area A1 in the subsequent AS-ALD step. FIG 8 (top) schematically depicts the device at a stage during manufacturing following deposition of a cover layer 30. Due to the relative differences in deposition rate the cover layer 30 is selectively deposited on the insulating area A2 of the electrode layer 11 and on the unpatterned buffer layer 16a. The remaining portion of the sacrificial layer 12a (corresponding to area A1) and the exposed portions of the semi-conductor layer (areas A3) remain uncovered. FIG 8 (bottom) schematically depicts formation of electrically conductive metal contact pads 42,43 on the contact areas of the electrode layer 11 and the semi-conductor layer 17 after a removal of the remaining portion of the sacrificial layer and following a metallization process.

As described earlier suitable material combinations may be known form literature and/or identified experimentally. In an exemplary embodiment of manufacturing of a TFT device one of the electrode layer 11 and the further electrode layer 17 comprises, preferably essentially consists of, a metal, e.g., molybdenum and the other of the electrode layer 11 and the further electrode layer 17 comprises, preferably essentially consists of, indium gallium zinc oxide (IGZO). The gate insulator layer 18 and/or buffer layer 16a can each comprise (essentially consists of) a metal or semi-conductor oxide, e.g. silicon oxide. In a preferred embodiment, the sacrificial layer 12 is a layer of AlOₓ 12m. In other or further preferred embodiments, the cover layer 30 of a cover material 30m is a layer of SiOₓ 30m.

Table I summarizes observed layer deposition on various materials following exposure to the area selective ALD process AS-ALD.

**Table I: Selective layer deposition of SiOₓ on substrate with:**

| No blanket sacrificial layer | | | Blanket sacrificial AlOₓ layer | |
|---|---|---|---|---|
| SiO₂ | yes | | SiO₂ | yes |
| IGZO | no deposition | | IGZO | no deposition |
| Molybdenum | yes | | Molybdenum | yes |
| | | | Molybdenum covered with AlOₓ | no |

The left two columns pertain to a comparative TFT manufacturing process using a stack of layers comprising IGZO as semiconducting further electrode layer 17 and molybdenum as electrode layer 11. In the comparative example no blanket sacrificial layer 12 was used. Following the AS-ALD process no SiOₓ was found to be deposited on the IGZO layer. As no sacrificial layer 12 was used the entire electrode layer 11 was exposed during the SA-ALD process and accordingly the complete electrode was found to be covered in an insulating oxide layer. For the TFT device made according to the comparative method a number of subsequent pattering steps (e.g., photolithography and etching) would be required in order to provide a contactable area for the electrode. In contrast, the right most two columns of Table I pertain to TFT manufactured according to the method of the invention, including deposition of a blanket sacrificial AlOₓ layer. Following the AS-ALD process no SiOₓ was found to be deposited on the IGZO layer not on the portion 12a of AlOₓ layer covering the contact areas A2 of the electrode. As a sacrificial layer 12 was used the electrode 11 was successfully selectively covered during the SA-ALD process. Accordingly, to open the contact area to the electrode a simple wet or dry etching step was found to suffice. Wet etch examples for Al₂O₃ include diluted HF solutions in de-ionized water, wherein dilute HF solutions can be understood as HF to water ratios ranging from 200:1 to 50:1 (mass:mass) for which etching rates for ALD-grown (and PDA-annealed) Al₂O₃ were reported from 0.6 to 0.1 nm/sec (e.g., as reported by C. Lee et al., in, Abstract 845, 206th ECS Meeting, 2004). Wet etchant examples for Al₂O₃ further include watery solutions of H₃PO₄ / CrO₃, e.g., 50 mL of H₃PO₄ with 7 mL CrO₃ (500 g/L) in 1 liter of H₂O, at 80-95 °C (e.g., as reported in J. Electrochem. Soc., March 1978, p. 470). Dry etch examples for Al₂O₃ include: CF₄ and/or CHF₃ plasmas, and O₂/BCl₃/Ar plasma(as reported by X. Yang et al., in Trans. Electr. Electron. Mater. 11(5) 202 (2010).

In line with the above, further aspects of the present invention pertain to use of a pattern transfer process on a thin film stack in combination with the area selective ALD process. In particular in the use of pattern transfer process on a thin film stack comprising a blanket sacrificial layer covering an electrode layer 11, to form a patterned sacrificial layer 12 covering a pre-defined portions of the electrode layer 11. Advantageously, the patterned structure provides chemical contrast in the subsequent area selective ALD process. In some embodiments, the use of a pattern transfer process on a thin film stack in combination with the area selective ALD process is used in the manufacturing of transistors, e.g., MOSFET devices or TFT devices.

For the purpose of clarity and a concise description, features are described herein as part of the same or separate embodiments, however, it will be appreciated that the scope of the invention may include embodiments having combinations of all or some of the features described. Of course, it is to be appreciated that any one of the above embodiments or processes may be combined with one or more other embodiments or processes to provide even further improvements in finding and matching designs and advantages. It is appreciated that this disclosure offers particular advantages to manufacturing of complex microelectronic devices, and in general can be applied for any application benefitting from area selective deposition of materials, in particular devices which would otherwise require an additional patterning step to pattern a functional layer, e.g., a photolithographic patterning step to provide a contactable area for an electrode. Furthermore, it will be understood that the method is not to be construed as to be limited to imprint lithography templates at two levels nor to three levels (layers) with two imprint levels. On the contrary, the method can be used to equal advantage in more extensive methods using imprint lithography templates with more than three, e.g., a multitude of levels. For example, the method can be applied in the manufacturing of optical structures using nanoimprint lithography templates having in excess of ten or more levels. Likewise, the method can be used to equal advantage in methods using multiple, e.g., subsequent, imprint lithography templating steps.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. Method of manufacturing a semi-conducting thin film device (100), the method comprising:
- providing a thin film stack (10) comprising an electrode layer (11),
- depositing a blanket sacrificial layer (12) covering the electrode layer (11),
- providing a multilevel nanoimprint lithography template (20) on the blanket sacrificial layer (12), wherein the multilevel nanoimprint lithography template (20) comprises:
∘ at least a first portion (P1) at a first level (LI) that corresponds to a pre-defined electrical contact area (A1) of the electrode layer (11),
∘ and a second portion (P2) at a second level (L2), different from the first level, that corresponds to a pre-defined insulating area (A2) of the electrode layer (11),
- transferring (T) the multilevel nanoimprint lithography template (20) into the thin film stack (10), thereby patterning the thin film device (100) and exposing the predefined insulating area (A2) of the electrode layer while keeping a remaining portion (12a) of the blanket sacrificial layer (12) that covers the pre-defined electrical contact area (A1) of the electrode layer (11);
- performing an area selective ALD process (AS-ALD) to selectively cover the exposed area of the electrode layer (11) with a cover layer (30) of a cover material (30m),
the area selective ALD process arranged to have a deposition rate of the cover material (30m) that is comparatively higher on the electrode layer (11) than on the sacrificial layer (12), and
- removing the remaining portion (12a) of the sacrificial layer (12) to expose the electrical contact area (A1) of the electrode layer (11).

2. The method according to claim 1, wherein:
- the provided thin film stack (10) comprises a buried further electrode layer (17) and an insulator layer 18 separating the electrode layer (11) and the further electrode layer (17), and wherein
- the multilevel nanoimprint lithography template (20) comprises a further portion (P3) at a further level (L3), different from the first and second level, that corresponds to a pre-defined contact area (A3) of the further electrode layer (17) and wherein, upon transfer, the pre-defined contact area (A3) of the further electrode layer (17) is exposed.

3. The method according to claim 2, wherein the deposition rate of the cover material (30m) on the electrode material (11m) is comparatively higher than on the further electrode layer (17).

4. The method according to any of claims 1-3, wherein the method further comprises one or more back-etch process steps to remove part of the deposited cover material (30m).

5. The method according to any of claims 1-4, wherein, the method comprises performing a metallizing process to form an electrically conductive contact pad (41) on the exposed contact area (A1) of the electrode layer (11).

6. The method according to any of claims 1-5, wherein the area selective ALD process (AS-ALD) is an area selective spatially resolved ALD process.

7. The method according to any of claims 1-6, wherein the method comprises performing a metallizing process to form electrically conductive contact pads (41, 42) on the exposed contact areas (A1, A3) of both the electrode layer and the further electrode layer (11, 17).

8. The method according to any of claims 2-7, wherein, the method is arranged for the manufacturing of a transistor device and wherein:
- one of the electrode layer (11) and the electrode layer (17) is arranged to form a gate (110); and the other is arranged to form a semi-conducting charge carrier layer (170), and wherein the
- the insulator layer 18 is arranged to form a gate insulator (180).

9. The method according to any of claims 2-8, wherein, the method is arranged for the manufacturing of a TFT device (1000) and wherein,
- one of the electrode layer (11) and the further electrode layer (17) essentially consists of a metal, e.g., molybdenum; and
- the other of the electrode layer (11) and the further electrode layer (17) essentially consists of indium gallium zinc oxide; and
- the gate insulator layer (18) essentially consists of silicon oxide.
